# EUROPEAN PATENT APPLICATION

(11) **EP 4 693 400 A1**
(43) Date of publication of application: **11.02.2026**
(21) Application number: 24936196.5
(22) Date of filing: 15.10.2024
(51) Int. Cl.: H01L 23/544, H01L 21/768, H01L 23/522, H01L 21/78, H01L 23/31

(54) **SEMICONDUCTOR STRUCTURE, SEMICONDUCTOR APPARATUS, AND PREPARATION METHOD FOR SEMICONDUCTOR STRUCTURE**

(30) Priority: 09.05.2024 CN 202410567812
(71) Applicant: CXMT Corporation, Hefei, Anhui 230601 (CN)
(72) Inventor: FANG, Yang, Hefei, Anhui 230601 (CN); LU, Zhiyuan, Hefei, Anhui 230601 (CN); FAN, Yuan, Hefei, Anhui 230601 (CN); ZHOU, Haolei, Hefei, Anhui 230601 (CN); QUAN, Changhao, Hefei, Anhui 230601 (CN)
(74) Representative: Gulde & Partner
(86) International application number: PCT/CN2024/124885
(87) International publication number: WO 2025/232090

(57) **Abstract**

A semiconductor structure, a semiconductor apparatus, and a method for manufacturing a semiconductor structure are provided. The semiconductor structure includes: a wafer, the wafer being divided into a plurality of chip areas and a scribe line region located between two adjacent chips; seal ring structures, each of the seal ring structures being disposed between one of the plurality of chip areas and the scribe line region; a metal pad layer, the metal pad layer being paved all over the scribe line region and the metal pad layer being located on one side of the scribe line region close to the wafer; and pseudo seal ring structures, the pseudo seal ring structures filling the scribe line region and being disposed on the metal pad layer.

## Description

The present disclosure claims priority to Chinese Patent Application No. 202410567812.8 filed with China National Intellectual Property Administration on May 09, 2024 and entitled "SEMICONDUCTOR STRUCTURE, SEMICONDUCTOR APPARATUS, AND METHOD FOR MANUFACTURING SEMICONDUCTOR STRUCTURE", the content of which is incorporated herein by reference in its entirety.

### TECHNICAL FIELD

The present application relates to the field of integrated circuit technologies, and in particular, to a semiconductor structure, a semiconductor apparatus, and a method for manufacturing a semiconductor structure.

### BACKGROUND

During the manufacturing of a semiconductor structure, a plurality of chips and scribe lines for dividing the chips are formed on a wafer, and the entire wafer is cut along the scribe lines to form the chips. However, the low dielectric material or the oxide material in the scribe lines is prone to crack or break during cutting.

Therefore, how to prevent the material in the scribe lines from cracking or breaking in the wafer cutting process is still a problem urgently to be solved.

### SUMMARY

Accordingly, the present application provides a semiconductor structure, a semiconductor apparatus, and a method for manufacturing a semiconductor structure, which can prevent a material in a scribe line from cracking or breaking in a wafer cutting process.

In one aspect, the present application provides a semiconductor structure according to some embodiments, which includes:
a wafer, the wafer being divided into a plurality of chip areas and a scribe line region located between two adjacent chip areas;
seal ring structures, each of the seal ring structures being disposed between one of the plurality of chip areas and the scribe line region;
a metal pad layer, the metal pad layer being paved all over the scribe line region and the metal pad layer being located on one side of the scribe line region close to the wafer; and
pseudo seal ring structures, the pseudo seal ring structures filling the scribe line region and being disposed on the metal pad layer.

In some embodiments, the scribe line region includes enhanced structure areas and linear structure areas, where
each of the enhanced structure areas is disposed close to one of the seal ring structures;
each of the linear structure areas is disposed on one side of one of the enhanced structure areas far away from one of the seal ring structures.

In some embodiments, each of the pseudo seal ring structures in the enhanced structure area includes a contact and an interconnection line;
the metal pad layer, the contact, and the interconnection line are sequentially connected in a direction perpendicular to the wafer;
two adjacent interconnection lines of the pseudo seal ring structures are partially connected.

In some embodiments, positions in which the two adjacent interconnection lines of the pseudo seal ring structures are partially connected are distributed in a staggered manner.

In some embodiments, the pseudo seal ring structures of the linear structure area include a first linear pseudo seal ring structure and a second linear pseudo seal ring structure;
the first linear pseudo seal ring structure includes a third contact and a third interconnection line, and the metal pad layer, the third contact, and the third interconnection line are sequentially connected in a direction perpendicular to the wafer;
the second linear pseudo seal ring structure includes a fourth interconnection line, and the fourth interconnection line is disposed above the metal pad layer;
the first linear pseudo seal ring structure and the second linear pseudo seal ring structure are arranged discontinuously.

In some embodiments, a projection of the contact on the scribe line region has a closed ring shape;
a projection of the interconnection line on the scribe line region has a closed ring shape.

In another aspect, the present application further provides a semiconductor apparatus according to some embodiments, which includes:
chips;
a scribe line surrounding the chips;
seal ring structures, each of the seal ring structures being disposed between one of the chips and the scribe line;
a metal pad layer, the metal pad layer being paved all over the scribe line; and
pseudo seal ring structures, the pseudo seal ring structures filling the scribe line and the pseudo seal ring structures being located on the metal pad layer.

In some embodiments, the scribe line includes enhanced structure areas, and each of the enhanced structure areas is disposed close to one of the seal ring structures;
each of the pseudo seal ring structures in the enhanced structure area includes a contact and an interconnection line;
the metal pad layer, the contact, and the interconnection line are sequentially connected in a direction perpendicular to the wafer;
two adjacent interconnection lines of the pseudo seal ring structures are partially connected;
positions in which the two adjacent interconnection lines of the pseudo seal ring structures are partially connected are distributed in a staggered manner.

In some embodiments, the scribe line further includes linear structure areas, and each of the linear structure areas is disposed on one side of one of the enhanced structure areas far away from one of the seal ring structures;
the pseudo seal ring structures of the linear structure area include a first linear pseudo seal ring structure, the first linear pseudo seal ring structure includes a third contact and a third interconnection line, and the metal pad layer, the third contact, and the third interconnection line are sequentially connected in the direction perpendicular to the wafer;
the pseudo seal ring structures of the linear structure area include a second linear pseudo seal ring structure;
the second linear pseudo seal ring structure includes a fourth interconnection line, and the fourth interconnection line is disposed above the metal pad layer.

In another aspect, the present application further provides a method for manufacturing a semiconductor structure according to some embodiments, which includes:
providing a wafer including a plurality of chip areas and a scribe line region between two adjacent chip areas, where the scribe line region includes enhanced structure areas and linear structure areas, each of the enhanced structure areas is disposed close to a seal ring structure, and each of the linear structure areas is disposed on one side of one of the enhanced structure areas far away from a seal ring structure;
forming seal ring structures, each of the seal ring structures being disposed between one of the plurality of chip areas and the scribe line region;
forming a metal pad layer, the metal pad layer being formed in the scribe line region and paved all over the scribe line region; and
forming pseudo seal ring structures, the pseudo seal ring structures filling the scribe line region and the pseudo seal ring structures being formed on the metal pad layer.

In some embodiments, contacts are formed on the metal pad layer, where the contacts are mutually separated, and a projection of each of the contacts on the scribe line region has a closed ring shape;
interconnection lines are formed, where the interconnection lines are mutually separated, and a projection of each of the interconnection lines on the scribe line region has a closed ring shape;
two adjacent interconnection lines formed in the enhanced structure area are partially connected, and positions for partial connections are distributed in a staggered manner;
the interconnection lines formed in the linear structure area include a third interconnection line connected to the contact and a fourth interconnection line not connected to the contact, and a third interconnection line connected to the contact and the fourth interconnection line not connected to the contact are arranged discontinuously.

The semiconductor structure and the method for manufacturing the same provided in the present application have at least the following beneficial effects:
According to the semiconductor structure, the semiconductor apparatus, and the method for manufacturing a semiconductor structure provided in the present application, the metal pad layer is formed in the scribe line and paved on the entire scribe line, the scribe line is filled with the pseudo seal ring structures, and the pseudo seal ring structures are formed on the metal pad layer, so that the pseudo seal ring structures and the metal pad layer jointly divide a low dielectric material or an oxide material in the scribe line into a plurality of small blocks, and the low dielectric material or the oxide material in the scribe line can be well prevented from cracking in the wafer cutting process.

### BRIEF DESCRIPTION OF THE DRAWINGS

To more clearly illustrate the technical solutions in the embodiments of the present application or the conventional technology, a brief introduction to the drawings required for the description of the embodiments or conventional technology is given hereinafter. It is evident that the drawings described hereinafter are merely some embodiments of the present application. For those of ordinary skill in the art, other drawings may also be obtained based on these drawings without creative effort.
FIG. 1 is a schematic plan view of a semiconductor structure provided according to some embodiments of the present application;
FIG. 2 is a partial plan view of an area A in the semiconductor structure provided in FIG. 1 according to some embodiments of the present application;
FIG. 3 is an enlarged partial plan view of an area A in the semiconductor structure provided in FIG. 1 according to some embodiments of the present application;
FIG. 4 is a schematic cross-sectional structural view of a semiconductor structure provided according to some embodiments of the present application;
FIG. 5 is a schematic cross-sectional structural view of the semiconductor structure provided in FIG. 3 along a cutting line AA according to some embodiments of the present application;
FIG. 6 is a schematic cross-sectional structural view of the semiconductor structure provided in FIG. 3 along a cutting line BB according to some embodiments of the present application;
FIG. 7 is a schematic cross-sectional structural view of the semiconductor structure provided in FIG. 3 along a cutting line CC according to some embodiments of the present application;
FIG. 8a, FIG. 8b, and FIG. 8c are enlarged partial plan views of an area 402 in the semiconductor structure provided in FIG. 3 according to some embodiments of the present application;
FIG. 9 is a partial plan view of an area B in the semiconductor structure provided in FIG. 1 according to some embodiments of the present application;
FIG. 10 is a partial plan view of an area C in the semiconductor structure provided in FIG. 1 according to some embodiments of the present application;
FIG. 11 is a partial plan view of an area C in the semiconductor structure provided in FIG. 1 according to some other embodiments of the present application.

Reference numerals in the figures are as follows:
1. Chip area; 101. Chip; 2. Seal ring structure; 3. Scribe line region; 4. Pseudo seal ring structure; 401. Enhanced pseudo seal ring structure; 402. Linear pseudo seal ring structure; 6. First linear pseudo seal ring structure; 7. Second linear pseudo seal ring structure; 8. Metal pad layer; 9. Contact; 901. First contact; 902. Second contact; 903. Third contact; 10. Interconnection line; 1001. First interconnection line; 1002. Second interconnection line; 1003. Third interconnection line; 1004. Fourth interconnection line.

### DETAILED DESCRIPTION

To facilitate understanding of the present application, a more comprehensive description of the present application will be provided hereinafter with reference to the relevant drawings. The drawings illustrate the preferred embodiments of the present application. However, the present application can be implemented in many different forms and is not limited to the embodiments described herein. Rather, these embodiments are provided to make the disclosed content of the present application more thorough and comprehensive.

Unless otherwise defined, all technical and scientific terms used herein have the same meaning as commonly understood by those skilled in the art to which the present application belongs. The terms used in the specification of the present application are for the purpose of describing particular embodiments only and are not intended to limit the present application.

It should be understood that when an element or layer is referred to as being "on", "adjacent to", or "connected to" another element or layer, it may be directly on, adjacent to, or connected to the another element or layer, or an intervening element or layer may be present. It should be understood that, although the terms first, second, etc., may be used to describe various elements, components, areas, layers, doping types, and/or portions, the elements, components, areas, layers, doping types, and/or portions should not be limited by these terms. These terms are only used to distinguish one element, component, area, layer, doping type, or portion from another element, component, area, layer, doping type, or portion. Thus, a first element, component, area, layer, doping type, or portion discussed below could be termed a second element, component, area, layer, doping type, or portion without departing from the teachings of the present application. For example, a first doped area may be referred to as a second doped area, and similarly, a second doped area may be referred to as a first doped area. The first doped area and the second doped area are different doped areas.

Spatial relationship terms such as "on" may be used herein to describe the relationship of one element or feature to another element or feature as illustrated in the figures. It should be understood that the spatial relationship terms include different orientations of the device in use or operation in addition to the orientation illustrated in the figures. For example, if the device in the figures is turned over, an element or feature described as "on" another element or feature would be oriented "under" the another element or feature. Thus, the exemplary term "on" may include both up and down orientations. In addition, the device may include additional orientations (e.g., rotated 90 degrees or at other orientations), and the spatial descriptive terms used herein should be interpreted accordingly.

As used herein, the singular forms "a", "an", and "the" may include the plural forms as well, unless the context clearly indicates otherwise. It should also be understood that the terms "comprise" and/or "include" when used in the specification, specify the presence of stated features, integers, steps, operations, elements, and/or components, but do not preclude the presence or addition of one or more other features, integers, steps, operations, elements, components, and/or groups. Additionally, as used herein, the term "and/or" includes any and all combinations of the associated listed items.

The embodiments of the invention are described here with reference to the schematic cross-sectional views of the ideal embodiments (and intermediate structures) of the present application, such that variations in the shapes shown are to be expected, for example, due to manufacturing techniques and/or tolerances. Thus, the embodiments of the present application should not be limited to the particular shapes of areas illustrated herein, but are to include deviations in shapes that result, for example, from manufacturing techniques. The areas illustrated in the figures are essentially illustrative, and their shapes do not represent the actual shapes of areas of devices and do not limit the scope of the present application.

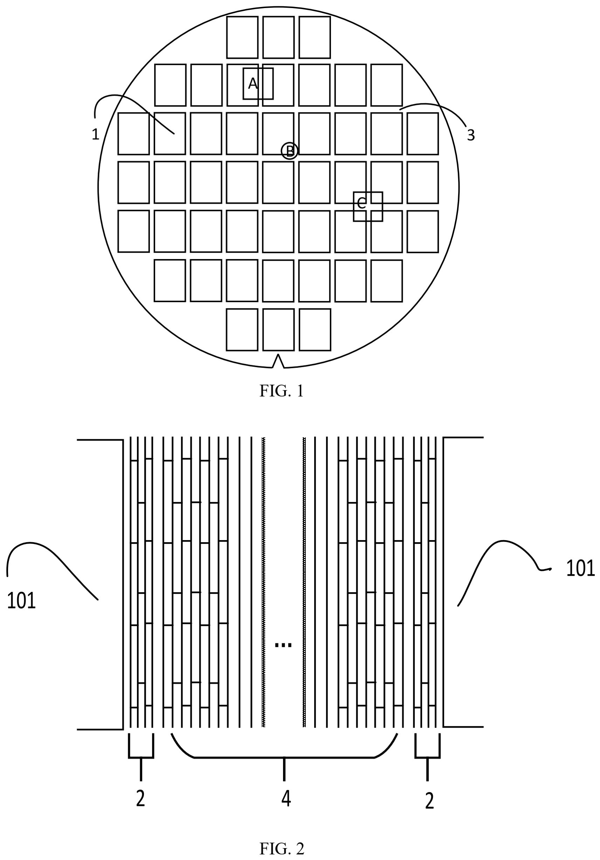

FIG. 1 is a schematic plan view of a semiconductor structure provided according to some embodiments of the present application. Referring to FIG. 1, a wafer includes a plurality of chip areas 1 and a scribe line region 3 between two adjacent chip areas. In this embodiment, the plurality of chip areas 1 may be formed in arrays on the wafer. The wafer may be a silicon wafer, a silicon germanium wafer, a silicon carbide wafer, a silicon-on-insulator (SOI) wafer, a germanium-on-insulator (GOI) wafer, a glass wafer, a group III-V compound wafer (for example, silicon nitride or gallium arsenide), an oxide semiconductor wafer, or another wafer that can be cut. A size of the wafer may be 6 inches, 8 inches, or 12 inches, and is not limited. The chip areas 1 may form computing-based chips, memory-based chips, image-based chips, and other chips manufactured in the wafer that include a plurality of devices (not shown). The chip areas 1 may be arranged in arrays of rectangles or squares on the wafer according to design requirements, and a size and formation of the chip area 1 are not particularly limited. The scribe line region 3 is disposed between two adjacent chip areas 1, and the scribe line region 3 is arranged as grids and divides the wafer into a plurality of independent chip areas 1. In some disclosed embodiments, the scribe line region is filled with a low dielectric material or some silicon oxide materials (not shown). Due to the stress of the low dielectric material or the silicon oxide material generated under a high temperature in a wafer cutting process, the low dielectric material or the silicon oxide material may crack, thereby affecting cutting quality and even causing damage to devices in the chip.

FIG. 2 is a partial plan view of an area A of the semiconductor structure provided in FIG. 1 according to some embodiments of the present application. Referring to FIG. 2, the wafer further includes seal ring structures 2, and each seal ring structure 2 is disposed around a chip 101 and located between the chip 101 and the scribe line region 3. The seal ring structure in this embodiment may be a one-ring, two-ring, or multiple-ring structure. In the wafer cutting process, the seal ring structure can protect the devices in the chip from being damaged.

Still referring to FIG. 2, a pseudo seal ring structure 4 is disposed in the scribe line region 3. The pseudo seal ring structure 4 and the seal ring structure 2 are disposed side by side, a distance between adjacent pseudo seal ring structures 4 may be greater than a distance between adjacent seal rings 2, and a shape of the pseudo seal ring structure 4 may be the same as, partially the same as, partially different from, or completely different from a shape of the seal ring structure 2. The pseudo seal ring structure 4 divides the scribe line region 3 into blocks of different sizes, so that the stress applied to the low dielectric material or the silicon oxide material in the scribe line 3 in the cutting process is decomposed, and thus the devices in the chip area 1 can be relatively easily protected from being damaged.

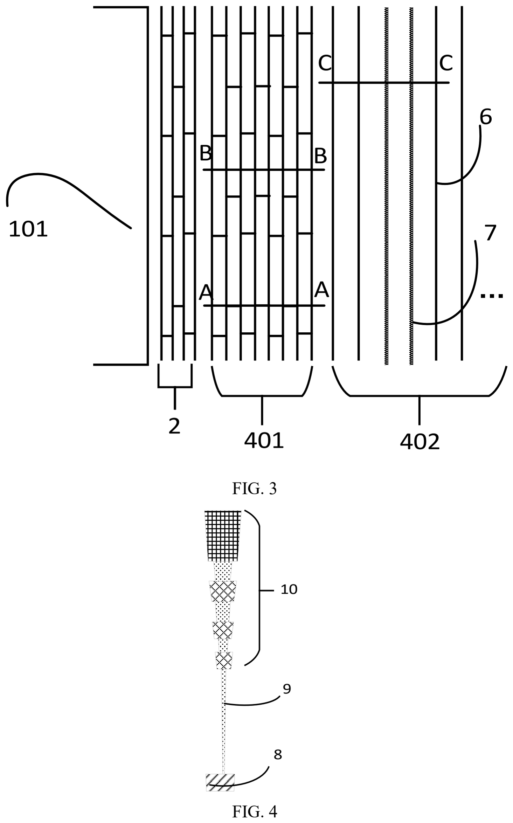

FIG. 3 is an enlarged partial plan view of an area A of the semiconductor structure provided in FIG. 1 according to some embodiments of the present application. Specifically, in some embodiments of the present application, the scribe line region 3 may include an enhanced structure area and a linear structure area. The enhanced structure area is closer to the seal ring 2, and the linear structure area is disposed on one side of the enhanced structure area away from the seal ring 2. It may be understood as that a cutting line from one chip 101 to an adjacent chip 101 includes the chip 101-the seal ring structure 2-the enhanced structure area-the linear structure area-the enhanced structure area-the seal ring structure 2-the chip 101. Sizes of the enhanced structure area and the linear structure area may be set according to a size of the scribe line. For example, when the size of the scribe line region 3 is 30 µm, 40 µm, 50 µm, or 60 µm, the enhanced structure area may be smaller than the linear structure area. For example, a size of the enhanced structure area may be 5 µm, 8 µm, 10 µm, or 12 µm. When the size of the scribe line region 3 is 65 µm, 75 µm, 85 µm, or 100 µm, the size of the enhanced structure area may be 15 µm, 18 µm, 21 µm, or 25 µm. The size of the scribe line region 3, the sizes of the enhanced structure area and the linear structure area, and a ratio therebetween are not limited and may be adjusted according to design requirements. Although shapes of pseudo seal ring structures 4 of the enhanced structure area and the linear structure area are different, the pseudo seal ring structures all divide the low dielectric material or the silicon oxide material in the scribe line region into many small blocks, so that the chip 101 and the seal ring 2 can be effectively prevented from being damaged in the wafer cutting process.

Still referring to FIG. 3, the enhanced structure area and the linear structure area are both disposed in the scribe line region 3, and the enhanced structure area is closer to the chip area 1 and the seal ring structure. Because the linear structure area is easier to cut, a cutter or laser can be prevented from shifting toward the chip 101 or the seal ring structure 2 during wafer cutting.

FIG. 4 is a schematic cross-sectional structural view of the semiconductor structure provided in FIG. 3 according to some embodiments of the present application. The scribe line region 3 includes a metal pad layer 8, a contact 9, and an interconnection line 10, and the metal pad layer 8, the contact 9, and the interconnection line 10 are stacked and connected in a direction perpendicular to a surface of the wafer to form a whole. In some embodiments, a projection of the contact 9 and the interconnection line 10 on the scribe line region has a seal ring shape. In the wafer cutting process, they may serve as a seal ring structure to effectively prevent the chip 1 and the seal ring 2 from being damaged.

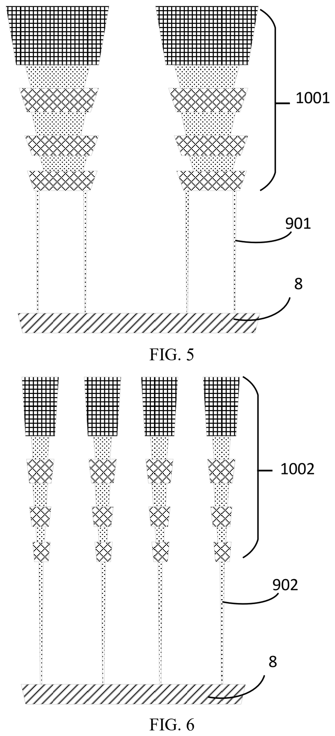

FIG. 5, FIG. 6, and FIG. 7 are schematic cross-sectional structural views of the semiconductor structure provided in FIG. 3 along cutting lines AA, BB, and CC, respectively, according to some embodiments of the present application. Specifically, in some embodiments, the metal pad layer 8 is disposed in the scribe line region 3, and the metal pad layer 8 is located on one side of the scribe line region 3 close to the wafer, that is, at the bottom of the scribe line region 3. A material of the metal pad layer 8 may be copper, tungsten, aluminum, cobalt, nickel, or a compound of two or more of the above metals, and the metal pad layer 8 may also have a plurality of layers. One or more barrier material layers (not shown) are formed around the metal pad layer 8 to block a metal material of the metal pad layer 8 from diffusing into a dielectric layer in the scribe line, and they can also improve adhesion between the metal pad layer 8 and the dielectric material in the scribe line region 3 and prevent cracks from occurring between the metal pad layer 8 and the dielectric material. A material of the barrier layer may be one or more of titanium, titanium nitride, tantalum, and tantalum nitride. The metal pad layer 8 is a whole in the scribe line region and is paved on the whole scribe line region 3, so that the pseudo seal ring structure 4 in the scribe line region 3 can be a whole, the pseudo seal ring structure 4 in the scribe line region 3 is enhanced, and thus the low dielectric material or the silicon oxide material can be better prevented from cracking in the cutting process.

Still referring to FIG. 4, FIG. 5, and FIG. 6, in some embodiments, the pseudo seal ring structure 4 formed in the enhanced structure area may be an enhanced pseudo seal ring structure 401. The enhanced pseudo seal ring structure 401 includes two portions: the contact 9 and the interconnection line 10; the contact 9 is connected to the metal pad layer 8, the interconnection line 10 is connected to the contact 9 and located above the contact 9, and the metal pad layer 8, the contact 9, and the interconnection line 10 are sequentially stacked in the direction perpendicular to the wafer to form a whole. A material of the contact 9 may be copper, tungsten, aluminum, cobalt, nickel, or a compound of two or more of the above metals. In addition, there may be a barrier material layer (not shown) around the contact 9 for blocking a metal material of the contact 9 from diffusing into the dielectric layer in the scribe line, which can also improve adhesion between the contact 9 and the dielectric material in the scribe line region 3 and prevent cracks from occurring between the contact 9 and the dielectric material. A material of the barrier layer may be one or more of titanium, titanium nitride, tantalum, and tantalum nitride. The interconnection line 10 may include a plurality of layers of metal lines and metal plug structures between the metal lines, and in some embodiments, may include three layers of metal lines and two layers of plug structures, four layers of metal lines and three layers of plug structures, five layers of metal lines and four layers of plug structures, or other layers of metal lines and plug structures. A material of the interconnection line 10 may be copper, tungsten, aluminum, cobalt, nickel, or a compound of two or more of the above metals, or one layer of the interconnection line may be copper, and another layer may be tungsten or aluminum, or metal materials of different layers may be different, and plug materials between metal layers may also be different. Referring to FIG. 5, in some embodiments, the enhanced pseudo seal ring structure 401 includes a first interconnection line 1001 (adjacent interconnection lines are connected together) and a first contact 901 connected to the first interconnection line 1001, and the first contact 901 is connected to the metal pad layer 8. Similarly, referring to FIG. 6, second contacts 902 and second interconnection lines 1002 of the enhanced pseudo seal ring structures 401 are independent of each other, and adjacent enhanced pseudo seal ring structures 401 are disposed side by side. Referring to FIG. 3, in some embodiments, first interconnection lines 1001 are distributed in a staggered manner, that is, the enhanced pseudo seal ring structures 401 are in a wall-type structure, so that adjacent pseudo seal ring structures are independent and supportive of each other, the strength is enhanced, the low dielectric material or the silicon oxide material in the scribe line region 3 is divided into smaller blocks, and the damage to the devices in the chip 101 can be better reduced during wafer cutting.

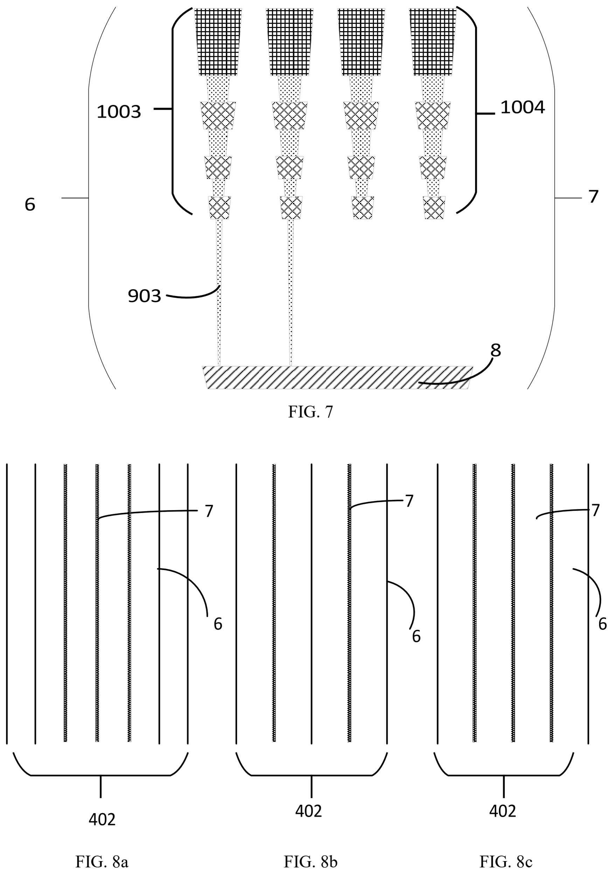

Referring to FIG. 3 and FIG. 7, pseudo seal ring structures of the linear structure area are arranged in rows outside the enhanced structure area, the pseudo seal ring structures of the linear structure area are linear pseudo seal ring structures 402, and an interval between linear pseudo seal ring structures 402 is greater than or equal to that between enhanced pseudo seal ring structures 401. The linear pseudo seal ring structure 402 may include a first linear pseudo seal ring structure 6 having a contact and connected to the metal pad layer 8 and a second linear pseudo seal ring structure 7 having no contact and not connected to the metal pad layer 8. Referring to FIG. 7, the first linear pseudo seal ring structure 6 includes a third contact 903 and a third interconnection line 1003, and the metal pad layer 8, the third contact 903, and the third interconnection line 1003 are sequentially stacked in the direction perpendicular to the wafer to form a seal ring structure. A material of the third contact 903 may be copper, tungsten, aluminum, cobalt, nickel, or a compound of two or more of the above metals. In addition, there may be a barrier material layer (not shown) around the third contact 903 for blocking a metal material of the contact from diffusing into the dielectric layer in the scribe line region, which can also improve adhesion between the third contact 903 and the dielectric material in the scribe line region and prevent cracks from occurring between the third contact 903 and the dielectric material. A material of the barrier layer may be one or more of titanium, titanium nitride, tantalum, and tantalum nitride. The third interconnection line 1003 may include a plurality of layers of metal lines and metal plug structures between the metal lines, and in some embodiments, may include three layers of metal lines and two layers of plug structures, four layers of metal lines and three layers of plug structures, five layers of metal lines and four layers of plug structures, or other layers of metal lines and plug structures. A material of the third interconnection line 1003 may be copper, tungsten, aluminum, cobalt, nickel, or a compound of two or more of the above metals, or one layer of the third interconnection line 1003 may be copper, and another layer may be tungsten or aluminum, or metal materials of different layers may be different, and plug materials between metal layers may also be different.

Still referring to FIG. 7, the linear pseudo seal ring structure 402 further includes the second linear pseudo seal ring structure 7 having no contact and not connected to the metal pad layer 8. The second linear pseudo seal ring structure 7 only has a fourth interconnection line structure 1004, has no contact, and is not connected to the metal pad layer 8; it is located in the low dielectric material or the silicon oxide material in the scribe line region and located on the same plane as the third interconnection line 1003 in the first linear pseudo seal ring structure 6. The second linear pseudo seal ring structure 7 is not provided with a contact, so that the process burden of etching contact holes can be reduced during manufacturing of a contact layer, materials and time cost can be saved, and the stress of the scribe line can be adjusted by adjusting the number of contacts.

FIG. 8a, FIG. 8b, and FIG. 8c are enlarged partial plan views of an area 402 in the semiconductor structure provided in FIG. 3 according to some embodiments of the present application. Referring to FIG. 7, the first linear pseudo seal ring structure 6 and the second linear pseudo seal ring structure 7 are arranged discontinuously. The number of first linear pseudo seal ring structures 6 arranged continuously is no more than five, and the number of second linear pseudo seal ring structures 7 arranged continuously is no more than five. In some embodiments, the first linear pseudo seal ring structures 6 and the second linear pseudo seal ring structures 7 are arranged at intervals, that is, one first linear pseudo seal ring structure 6 and one second linear pseudo seal ring structure 7 are a unit, and such arrangement is repeated, as shown in FIG. 8b. In some embodiments, two first linear pseudo seal ring structures 6 and two second linear pseudo seal ring structures 7 are arranged at intervals, that is, two first linear pseudo seal ring structures 6 and two second linear pseudo seal ring structures 7 are a unit, and such arrangement is repeated, as shown in FIG. 6. Similarly, two first linear pseudo seal ring structures 6 and three pseudo seal ring structures 7 are arranged at intervals, that is, two first linear pseudo seal ring structures 6 and three second linear pseudo seal ring structures 7 are a unit, and such arrangement is repeated, as shown in FIG. 8a; one first linear pseudo seal ring structure 6 and three second linear pseudo seal ring structures 7 are arranged at intervals, that is, one first linear pseudo seal ring structure 6 and three second linear pseudo seal ring structures 7 are a unit, and such arrangement is repeated, as shown in FIG. 8c.

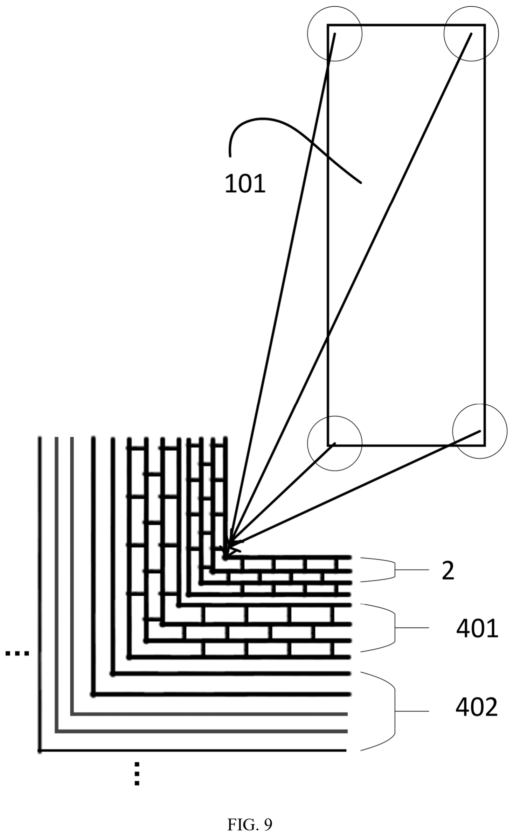

Referring to FIG. 2 and FIG. 9, FIG. 9 is a partial plan view of an area B in the semiconductor structure provided in FIG. 1 according to some embodiments of the present application. A projection of the pseudo seal ring structure 4 on the scribe line region 3 has a seal ring shape. The pseudo seal ring structure 4 extends from four corners of the chip 101 towards four sides of the chip, and its shape at the corner is the same as that in the area A. The contact 9 is connected to the metal pad layer 8, and a projection of the contact on the scribe line region 3 has a seal ring shape; the interconnection line 10 is connected to the contact 9, and a projection of the interconnection line on the scribe line region 3 has a seal ring shape. The pseudo seal ring structure 4 is a seal ring structure, which can better prevent the devices in the chip from being damaged in the wafer cutting process.

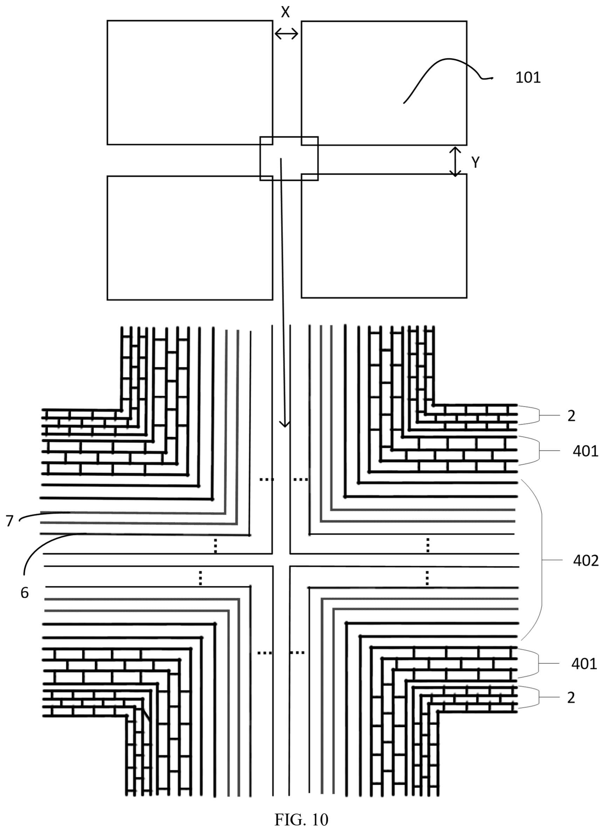

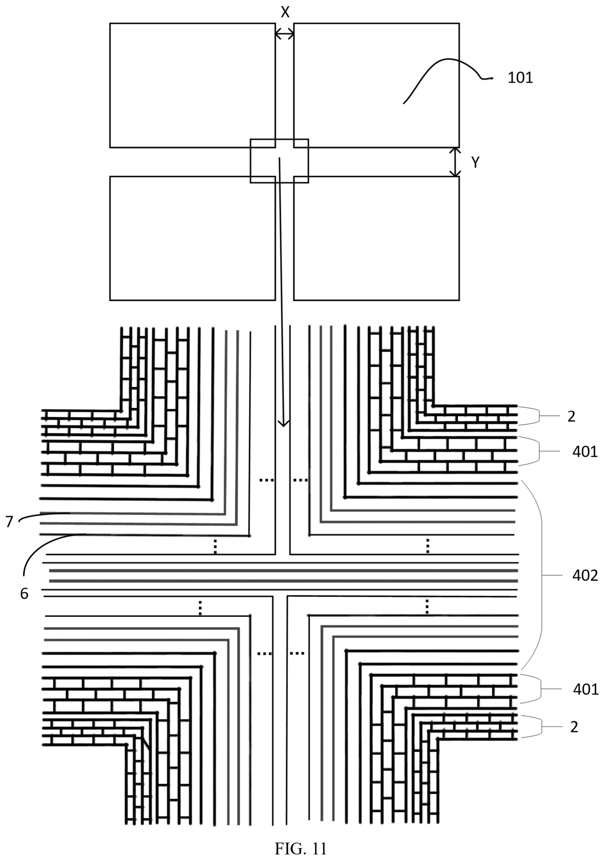

Referring to FIG. 1 and FIG. 10, the scribe line region 3 is arranged as grids on the wafer, that is, the scribe line region extends along a first direction and a second direction. A width of the scribe line region extending along the first direction is X, and a width of the scribe line region extending along the second direction is Y. When X is equal to Y, the width of the scribe line region 3 extending along the first direction is equal to the width of the scribe line region 3 extending along the second direction. When the widths along the first direction and the second direction are equal, because shapes and sizes of the pseudo seal ring structures 4 at the four corners and the four sides of the chip 101 are the same, referring to FIG. 10, shapes and sizes of the pseudo seal ring structure 4 in the scribe line region 3 extending along the first direction and in the scribe line region 3 extending along the second direction are also the same, and the pseudo seal ring structures may be arranged in line. When X is not equal to Y, that is, the width of the scribe line region 3 extending along the first direction is not equal to the width of the scribe line region 3 extending along the second direction, for example, X is smaller than Y, that is, the width of the scribe line region 3 extending along the first direction is smaller than the width of the scribe line region 3 extending along the second direction, referring to FIG. 11, in the scribe line region 3 extending along the second direction, a region with a width that is the difference in width between this scribe line region and the scribe line region 3 extending along the first direction is filled with a linear pseudo seal ring structure 4, the number of the pseudo linear seal ring structures 4 and the number of first linear pseudo seal ring structures 6 and the second linear pseudo seal ring structures 7 are determined according to a difference between Y and X, and an arrangement manner of the first linear pseudo seal ring structures 6 and the second linear pseudo seal ring structures 7 may be the same as or different from an arrangement manner of the first linear pseudo seal ring structures 6 and the second linear pseudo seal ring structures 7 around the chip. The pseudo seal ring structures 4 are uniformly filled in the scribe line region, so that the stress of the wafer can be adjusted, and the low dielectric material or the silicon oxide material in the wafer can be divided into small blocks. This can prevent the scribe line from cracking during wafer cutting and reduce the damage to the chip.

In another aspect, some embodiments of the present application further disclose a semiconductor apparatus, which includes: chips 101 manufactured by cutting along a scribe line region 3 of a wafer; a scribe line surrounding the chips, where a seal ring structure 2 is disposed between the chip 101 and the scribe line; a metal pad layer 8 located on one side of the scribe line close to the wafer and paved all over the bottom of the scribe line; and pseudo seal ring structures 4, the pseudo seal ring structures filling the scribe line and located above the metal pad layer 8.

Specifically, in some embodiments, the chip 101 may be a computing-based chip, a memory-based chip, an image-based chip, and another chip manufactured in the wafer that include a plurality of devices; the seal ring structure 2 may be a one-ring, two-ring, or multiple-ring structure. In a wafer cutting process, the seal ring structure 2 can protect devices in the chip from being damaged; the scribe line is disposed around the chip, is located outside the seal ring structure 2, and has a width large enough, so that the devices in the chip 101 are not damaged during wafer cutting; the metal pad layer 8 disposed in the scribe line is paved all over the bottom of the scribe line and exposed to a cutting surface of the scribe line, so that the stress of the wafer can be improved, the strength of the pseudo seal ring structure 4 in the scribe line can be enhanced, and the devices in the chip can be prevented from being damaged during wafer cutting.

Referring to FIG. 3, FIG. 4, FIG. 5, and FIG. 6, in some embodiments, the scribe line may include an enhanced structure area disposed close to the seal ring 2 and surrounding the seal ring structure. The pseudo seal ring structure located in the enhanced structure area is an enhanced pseudo seal ring structure 401. The enhanced pseudo seal ring structure 401 includes a contact 9 and an interconnection line 10, the contact 9 is connected to the metal pad layer 10, the interconnection line 10 is located above the contact 9 and is connected to the contact 9, and the metal pad layer 8, the contact 9, and the interconnection line 10 are sequentially stacked and connected in a direction perpendicular to the wafer. Adjacent interconnection lines of the pseudo seal ring structures are partially connected, and positions in which the adjacent interconnection lines of the pseudo seal ring structures are partially connected are distributed in a staggered manner. Specifically, in some embodiments, a material of the contact 9 may be copper, tungsten, aluminum, cobalt, nickel, or a compound of two or more of the above metals. In addition, there may be a barrier material layer (not shown) around the contact for blocking a metal material of the contact 9 from diffusing into the dielectric layer in the scribe line, which can also improve adhesion between the contact 9 and the dielectric material in the scribe line and prevent cracks from occurring between the contact 9 and the dielectric material. A material of the barrier layer may be one or more of titanium, titanium nitride, tantalum, and tantalum nitride. The interconnection line 10 may include a plurality of layers of metal lines and metal plug structures between the metal lines, and in some embodiments, may include three layers of metal lines and two layers of plug structures, four layers of metal lines and three layers of plug structures, five layers of metal lines and four layers of plug structures, or other layers of metal lines and plug structures. A material of the interconnection line 10 may be copper, tungsten, aluminum, cobalt, nickel, or a compound of two or more of the above metals, or one layer of the interconnection line may be copper, and another layer may be tungsten or aluminum, or metal materials of different layers may be different, and plug materials between metal layers may also be different. In some embodiments, positions in which adjacent pseudo seal ring structures are partially connected are distributed in a staggered manner, that is, the enhanced pseudo seal ring structures 401 are in a wall-type structure, so that the adjacent pseudo seal rings are independent and supportive of each other, the strength can be enhanced, the low dielectric material or silicon oxide material in the scribe line is divided into smaller blocks, and the damage to the devices in the chip can be better reduced during wafer cutting.

Referring to FIG. 3, FIG. 4, and FIG. 7, in some embodiments, the scribe line further includes a linear structure area surrounding the enhanced structure area. The pseudo seal ring structure of the linear structure area is a linear pseudo seal ring structure 402, and the linear pseudo seal ring structure 402 includes a first linear pseudo seal ring structure 6 having a contact and connected to the metal pad layer. Referring to FIG. 7, the first linear pseudo seal ring structure 6 includes a third contact 903 and a third interconnection line 1003, and the metal pad layer 8, the third contact 903, and the third interconnection line 1003 are sequentially stacked in the direction perpendicular to the wafer to form the first linear pseudo seal ring structure 6. A material of the third contact 903 may be copper, tungsten, aluminum, cobalt, nickel, or a compound of two or more of the above metals. In addition, there may be a barrier material layer (not shown) around the third contact 903 for blocking a metal material of the contact from diffusing into the dielectric layer in the scribe line, which can also improve adhesion between the third contact 903 and the dielectric material in the scribe line and prevent cracks from occurring between the third contact 903 and the dielectric material. A material of the barrier layer may be one or more of titanium, titanium nitride, tantalum, and tantalum nitride. The third interconnection line 1003 may include a plurality of layers of metal lines and metal plug structures between the metal lines, and in some embodiments, may include three layers of metal lines and two layers of plug structures, four layers of metal lines and three layers of plug structures, five layers of metal lines and four layers of plug structures, or other layers of metal lines and plug structures. A material of the third interconnection line 1003 may be copper, tungsten, aluminum, cobalt, nickel, or a compound of two or more of the above metals, or one layer of the third interconnection line 1003 may be copper, and another layer may be tungsten or aluminum, or metal materials of different layers may be different, and plug materials between metal layers may also be different.

In some embodiments, the linear pseudo seal ring structure 402 further includes a second linear pseudo seal ring structure 7 having no contact and not connected to the metal pad layer. The second linear pseudo seal ring structure 7 only has a fourth interconnection line structure 1004, has no contact, and is not connected to the metal pad layer 8; it is located in the low dielectric material or the silicon oxide material in the scribe line and located on the same plane as the third interconnection line in the first linear pseudo seal ring structure 6. The second linear pseudo seal ring structure 7 is not provided with a contact, so that the process burden of etching contact holes can be reduced during manufacturing of a contact layer, materials and time cost can be saved, and the stress of the scribe line can be adjusted by adjusting the number of contacts.

In another aspect, some embodiments of the present application further disclose a method for manufacturing a semiconductor structure, which includes: providing a wafer including a plurality of chip areas and a scribe line region between two adjacent chip areas; forming seal ring structures that are each located between the chip area and the scribe line region; forming a metal pad layer paved all over the bottom of the scribe line region; and forming pseudo seal ring structures formed on the metal pad layer and filling the scribe line region. Specifically, in some embodiments, the plurality of chip areas may be formed in arrays on the wafer. The wafer may be a silicon wafer, a silicon germanium wafer, a silicon carbide wafer, a silicon-on-insulator (SOI) wafer, a germanium-on-insulator (GOI) wafer, a glass wafer, a group III-V compound wafer (for example, silicon nitride or gallium arsenide), an oxide semiconductor wafer, or another wafer that can be cut. A size of the wafer may be 6 inches, 8 inches, or 12 inches, and is not limited. The chip areas may form computing-based chips, memory-based chips, image-based chips, and other chips manufactured in the wafer that include a plurality of devices (not shown). The chip areas may be arranged in arrays of rectangles or squares on the wafer according to design requirements, and a size and formation of the chip area are not particularly limited. The scribe line region is disposed between two adjacent chip areas. The scribe line region is arranged as grids and divides the wafer into a plurality of independent chip areas. In addition, in some embodiments, the scribe line region may include an enhanced structure area and a linear structure area, the enhanced structure area is closer to the seal ring, and the linear structure area is arranged on one side of the enhanced structure area far away from the seal ring.

In some embodiments, the metal pad layer is disposed in the scribe line region, and the metal pad layer is located on one side of the scribe line region close to the wafer, that is, at the bottom of the scribe line region. A material of the metal pad layer may be copper, tungsten, aluminum, cobalt, nickel, or a compound of two or more of the above metals, and the metal pad layer may also have a plurality of layers. One or more barrier material layers (not shown) are formed around the metal pad layer to block a metal material of the metal pad layer from diffusing into a dielectric layer in the scribe line region, and they can also improve adhesion between the metal pad layer and the dielectric material in the scribe line region and prevent cracks from occurring between the metal pad layer and the dielectric material. A material of the barrier layer may be one or more of titanium, titanium nitride, tantalum, and tantalum nitride. The metal pad layer is a whole in the scribe line and is paved on the whole scribe line region, so that the pseudo seal ring structure in the scribe line can be a whole, the pseudo seal ring structure in the scribe line is enhanced, and thus the low dielectric material or the silicon oxide material can be better prevented from cracking in the cutting process.

In some embodiments, the seal ring structure surrounds the chip area, and the seal ring structure may be a one-ring, two-ring, or multiple-ring structure. In the wafer cutting process, the seal ring structure can protect the devices in the chip from being damaged. The pseudo seal ring structure and the seal ring structure are disposed side by side, a distance between adjacent pseudo seal ring structures may be greater than a distance between adjacent seal rings, and a shape of the pseudo seal ring may be the same as, partially the same as, partially different from, or completely different from a shape of the seal ring. The pseudo seal ring structure divides the scribe line region into blocks of different sizes, so that the stress applied to the low dielectric material or the silicon oxide material in the scribe line region in the cutting process is decomposed, the cracking or breaking is correspondingly blocked, and thus the devices in the chip 1 can be relatively easily protected from being damaged.

In some embodiments, the contacts are formed on the metal pad layer, and the contacts are mutually separated; the projection of the contact on the scribe line region has a seal ring shape. Specifically, the contacts are disposed around the seal ring structure, and the contacts and the seal ring structure are formed synchronously. A material of the contact may be copper, tungsten, aluminum, cobalt, nickel, or a compound of two or more of the above metals. In addition, there may be a barrier material layer (not shown) around the contact for blocking a metal material of the contact from diffusing into the dielectric layer in the scribe line region, which can also improve adhesion between the contact and the dielectric material in the scribe line region and prevent cracks from occurring between the contact and the dielectric material. A material of the barrier layer may be one or more of titanium, titanium nitride, tantalum, and tantalum nitride.

In some embodiments, the interconnection lines are respectively formed on the contacts, the interconnection lines are mutually separated, and the projection of the interconnection line on the scribe line region has a closed ring shape. Specifically, the interconnection line may include a plurality of layers of metal lines and metal plug structures between the metal lines, and in some embodiments, may include three layers of metal lines and two layers of plug structures, four layers of metal lines and three layers of plug structures, five layers of metal lines and four layers of plug structures, or other layers of metal lines and plug structures. A material of the interconnection line may be copper, tungsten, aluminum, cobalt, nickel, or a compound of two or more of the above metals, or one layer of the interconnection line may be copper, and another layer may be tungsten or aluminum, or metal materials of different layers may be different, and plug materials between metal layers may also be different.

In some embodiments, two adjacent interconnection lines formed in the enhanced structure area are partially connected, and connection positions are distributed in a staggered manner, that is, the interconnection lines in the enhanced structure area are in a wall-type structure, so that adjacent interconnection lines are independent and supportive of each other, the strength can be enhanced, the low dielectric material or silicon oxide material in the scribe line can be divided into smaller blocks, and the damage to the devices in the chip can be better reduced during wafer cutting.

In some embodiments, interconnection lines formed in the linear structure area include an interconnection line connected to the contact and an interconnection line not connected to the contact, and the interconnection line connected to the contact and the interconnection line not connected to the contact are arranged discontinuously. Specifically, the metal pad layer, the contact, and the interconnection line connected to the contact form the first linear pseudo seal ring structure, and the metal pad layer and the interconnection line not connected to the contact form the second linear pseudo seal ring structure. Specifically, in some embodiments, the first linear pseudo seal ring structure includes a contact and an interconnection line, and the metal pad layer, the contact, and the interconnection line are sequentially stacked in the direction perpendicular to the wafer to form the seal ring structure. A material of the contact may be copper, tungsten, aluminum, cobalt, nickel, or a compound of two or more of the above metals. In addition, there may be a barrier material layer (not shown) around the contact for blocking a metal material of the contact from diffusing into the dielectric layer in the scribe line, which can also improve adhesion between the contact and the dielectric material in the scribe line and prevent cracks from occurring between the contact and the dielectric material. A material of the barrier layer may be one or more of titanium, titanium nitride, tantalum, and tantalum nitride. The interconnection line may include a plurality of layers of metal lines and metal plug structures between the metal lines, and in some embodiments, may include three layers of metal lines and two layers of plug structures, four layers of metal lines and three layers of plug structures, five layers of metal lines and four layers of plug structures, or other layers of metal lines and plug structures. A material of the interconnection line may be copper, tungsten, aluminum, cobalt, nickel, or a compound of two or more of the above metals, or one layer of the interconnection line may be copper, and another layer may be tungsten or aluminum, or metal materials of different layers may be different, and plug materials between metal layers may also be different. The second linear pseudo seal ring structure only has an interconnection line structure, has no contact, and is not connected to the metal pad layer; it is located in the low dielectric material or the silicon oxide material in the scribe line and located on the same plane with the interconnection line in the first linear pseudo seal ring structure. The second linear pseudo seal ring structure is not provided with a contact, so that the process burden of etching contact holes can be reduced during manufacturing of a contact layer, materials and time cost can be saved, and the stress of the scribe line region can be adjusted by adjusting the number of contacts.

It should be noted that the methods for manufacturing a semiconductor structure in the embodiments of the present application can all be used to manufacture the corresponding semiconductor structures. Therefore, the technical features in the method embodiments and those in the structural embodiments can be interchanged and mutually supplemented if without conflict, allowing those skilled in the art to learn the technical content of the present application.

The technical features of the above embodiments can be combined in any manner. For the sake of brevity, not all possible combinations of the technical features of the above embodiments are described. However, as long as there is no contradiction in the combination of these technical features, they should all be considered within the scope of the present disclosure.

The above embodiments merely express several implementations of the present application. The descriptions are relatively specific and detailed, but they should not be construed as limiting the scope of the patent application. It should be noted that for those of ordinary skill in the art, several modifications and improvements can be made without departing from the spirit of the present application, and these shall all fall within the protection scope of the present application. Therefore, the scope of patent protection of the present application shall be defined by the appended claims.

## Claims

1. A semiconductor structure, comprising:
a wafer, the wafer being divided into a plurality of chip areas (1) and a scribe line region (3) located between two adjacent chip areas (1);
seal ring structures (2), each of the seal ring structures (2) being disposed between one of the plurality of chip areas (1) and the scribe line region (3);
a metal pad layer (8), the metal pad layer (8) being paved all over the scribe line region (3) and the metal pad layer (8) being located on one side of the scribe line region (3) close to the wafer; and
pseudo seal ring structures (4), the pseudo seal ring structures (4) filling the scribe line region (3) and being disposed on the metal pad layer (8).

2. The semiconductor structure of claim 1, wherein
the scribe line region (3) comprises enhanced structure areas and linear structure areas;
each of the enhanced structure areas is disposed close to one of the seal ring structures (2);
each of the linear structure areas is disposed on one side of one of the enhanced structure areas far away from one of the seal ring structures (2).

3. The semiconductor structure of claim 2, wherein
each of the pseudo seal ring structures (4) located in the enhanced structure area comprises a contact (9) and an interconnection line (10);
the metal pad layer (8), the contact (9), and the interconnection line (10) are sequentially connected in a direction perpendicular to the wafer;
two adjacent interconnection lines (10) of the pseudo seal ring structures (4) are partially connected;
positions in which the two adjacent interconnection lines (10) of the pseudo seal ring structures (4) are partially connected are distributed in a staggered manner.

4. The semiconductor structure of claim 2, wherein
the pseudo seal ring structures (4) of the linear structure area comprise a first linear pseudo seal ring structure (6) and a second linear pseudo seal ring structure (7);
the first linear pseudo seal ring structure (6) comprises a third contact (903) and a third interconnection line (1003), and the metal pad layer (8), the third contact (903), and the third interconnection line (1003) are sequentially connected in a direction perpendicular to the wafer;
the second linear pseudo seal ring structure (7) comprises a fourth interconnection line (1004), and the fourth interconnection line (1004) is disposed above the metal pad layer (8);
the first linear pseudo seal ring structure (6) and the second linear pseudo seal ring structure (7) are arranged discontinuously.

5. The semiconductor structure of claim 3 or 4, wherein
a projection of the contact (9) on the scribe line region (3) has a closed ring shape;
a projection of the interconnection line (10) on the scribe line region (3) has a closed ring shape.

6. A semiconductor apparatus, comprising:
chips (101);
a scribe line surrounding the chips (101);
seal ring structures (2), each of the seal ring structures (2) being disposed between one of the chips (101) and the scribe line;
a metal pad layer (8), the metal pad layer (8) being paved all over the scribe line; and
pseudo seal ring structures (4), the pseudo seal ring structures (4) filling the scribe line and the pseudo seal ring structures (4) being located on the metal pad layer (8).

7. The semiconductor apparatus of claim 6, wherein
the scribe line comprises enhanced structure areas, and each of the enhanced structure areas is disposed close to one of the seal ring structures (2);
each of the pseudo seal ring structures (4) in the enhanced structure area comprises a contact (9) and an interconnection line (10);
the metal pad layer (8), the contact (9), and the interconnection line (10) are sequentially connected in a direction perpendicular to the wafer;
two adjacent interconnection lines (10) of the pseudo seal ring structures (4) are partially connected;
positions in which the two adjacent interconnection lines (10) of the pseudo seal ring structures (4) are partially connected are distributed in a staggered manner.

8. The semiconductor apparatus of claim 7, wherein
the scribe line further comprises linear structure areas, and each of the linear structure areas is disposed on one side of one of the enhanced structure areas far away from one of the seal ring structures (2);
the pseudo seal ring structures (4) of the linear structure area comprise a first linear pseudo seal ring structure (6), the first linear pseudo seal ring structure (6) comprises a third contact (903) and a third interconnection line (1003), and the metal pad layer (8), the third contact (903), and the third interconnection line (1003) are sequentially connected in the direction perpendicular to the wafer;
the pseudo seal ring structures (4) of the linear structure area comprise a second linear pseudo seal ring structure (7);
the second linear pseudo seal ring structure (7) comprises a fourth interconnection line (1004), and the fourth interconnection line (1004) is disposed above the metal pad layer (8).

9. A method for manufacturing a semiconductor structure, comprising:
providing a wafer comprising a plurality of chip areas (1) and a scribe line region (3) between two adjacent chip areas (1), wherein the scribe line region (3) comprises enhanced structure areas and linear structure areas, each of the enhanced structure areas is disposed close to a seal ring structure (2), and each of the linear structure areas is disposed on one side of one of the enhanced structure areas far away from a seal ring structure (2);
forming seal ring structures (2), each of the seal ring structures (2) being disposed between one of the plurality of chip areas (1) and the scribe line region (3);
forming a metal pad layer (8), the metal pad layer (8) being formed in the scribe line region (3) and paved all over the scribe line region (3); and
forming pseudo seal ring structures (4), the pseudo seal ring structures (4) filling the scribe line region (3) and the pseudo seal ring structures (4) being formed on the metal pad layer (8).

10. The method for manufacturing a semiconductor structure of claim 9, wherein
contacts (9) are formed on the metal pad layer (8), wherein the contacts (9) are mutually separated, and a projection of each of the contacts on the scribe line region (3) has a closed ring shape;
interconnection lines (10) are formed, wherein the interconnection lines (10) are mutually separated, and a projection of each of the interconnection lines on the scribe line region (3) has a closed ring shape;
two adjacent interconnection lines (10) formed in the enhanced structure area are partially connected, and positions of partial connections are distributed in a staggered manner;
the interconnection lines (10) formed in the linear structure area comprise a third interconnection line (1003) connected to the contact (9) and a fourth interconnection line (1004) not connected to the contact (9), and a third interconnection line (1003) connected to the contact (9) and the fourth interconnection line (1004) not connected to the contact (9) are arranged discontinuously.
